# EUROPEAN PATENT APPLICATION

(11) **EP 3 196 561 A1**
(43) Date of publication of application: **26.07.2017**
(21) Application number: 17151984.6
(22) Date of filing: 18.01.2017
(51) Int. Cl.: F24F 1/24

(54) **AIR CONDITIONER CONTROLLER AND AIR CONDITIONER INCLUDING THE SAME**

(30) Priority: 20.01.2016 JP 2016008858
(71) Applicant: Mitsubishi Heavy Industries Thermal Systems, Ltd., Minato-ku Tokyo 108-8215 (JP)
(72) Inventor: KOIKE, Kenta, TOKYO, 108-8215 (JP); SUMIYA, Atsuyuki, TOKYO, 108-8215 (JP); OONO, Kenzo, TOKYO, 108-8215 (JP)
(74) Representative: Intès, Didier Gérard André

(57) **Abstract**

An air conditioner controller (12) is provided that can achieve, as much as possible, reduction in the number of fixation holes formed in a substrate, which are necessary for fixing a heat generating electric component to a thermally conductive block, and provide an excellent operability at attachment and removal.

An aluminum block (25) includes a parallel surface (26) that extends substantially in parallel to a substrate (21) at a predetermined interval from the substrate (21) and to which a DIP type heat generating electric component (22) is attached, an orthogonal surface (27) that intersects with the parallel surface (26) and to which an SIP type heat generating electric component (23) is attached, and a refrigerant pipe fixation surface (31) to which a refrigerant pipe (10A) is attached, the refrigerant pipe fixation surface (31) being disposed facing to an opening part provided by removing a service panel (30B) of an outdoor unit.

## Description

### 1. FIELD OF THE INVENTION

The present invention relates to an air conditioner controller including a substrate on which a heat generating electric component such as a power transistor is mounted, and an air conditioner including the air conditioner controller.

### 2. DESCRIPTION OF RELATED ART

An air conditioner in which an inverter-driven instrument is incorporated includes a controller including a substrate on which heat generating electric components such as an active converter, a diode module, and a power transistor serving as an inverter are mounted. Recently, largely increased capacities of the inverter and its power elements have been requiring improvement in cooling performance of the controller. As a cooling scheme, a refrigerant cooling scheme that achieves cooling with a refrigerant has been increasingly employed in place of an air cooling scheme that achieves cooling with a cooling fin.

PTL 1 discloses a technology in which a refrigerant jacket made of an aluminum block (thermally conductive block) having a high thermal conductivity is disposed facing to a dual inline package (DIP) type electric component and a single inline package (SIP) type electric component mounted on a wiring substrate, a plurality of the above-described electric components are installed on a facing surface through screw fixation, a refrigerant pipe is disposed on a surface opposite to the facing surface in contact with the opposite surface, and the plurality of electric components generating heat are cooled by a refrigerant through the refrigerant jacket.

### CITATION LIST

### Patent Literature

(PTL 1) Japanese Patent No. 5472364.

### BRIEF SUMMARY OF THE INVENTION

When the refrigerant cooling scheme is employed as a controller cooling scheme as described above, the following problem occurs.

Since the area of a heat releasing surface decreases along with downsizing of an aluminum block, heat generating electric components have to be concentrated at part of a substrate. Fixation of the electric components to the aluminum block requires access to the aluminum block from the substrate side, and thus fixation holes used to fix the electric components have to be provided in the substrate. However, the occupancy area of the substrate is reduced when the electric components are concentrated, and accordingly, the pattern width of the substrate is reduced due to the fixation holes, making it difficult to obtain a sufficient current capacity. Moreover, the fixation holes reduce the mechanical strength of the substrate.

In addition, the operability needs to be improved for attachment work in a housing of an outdoor unit.

The present invention is intended to solve such a problem and aims at providing an air conditioner controller that can achieve, as much as possible, reduction in the number of fixation holes formed in a substrate, which are necessary for fixing a heat generating electric component to a thermally conductive block, and provide an excellent operability at attachment and removal, and an air conditioner including the air conditioner controller.

To solve the above-described problem, an air conditioner controller and an air conditioner including the same according to the present invention provide the following solutions.

Specifically, an air conditioner controller according to the present invention includes a plurality of heat generating electric components installed in an outdoor unit of an air conditioner to control instruments of the air conditioner; a substrate on which the heat generating electric components are mounted; and a thermally conductive block to which body parts of the heat generating electric components are fixed in contact and that is attached to a refrigerant pipe. The thermally conductive block includes a first surface that extends substantially in parallel to the substrate at a predetermined interval from the substrate and to which at least one of the heat generating electric components is attached, a second surface that intersects with the first surface and to which at least one SIP type heat generating electric component among the heat generating electric components is attached, and a third surface to which the refrigerant pipe is attached. The third surface is disposed facing to an opening part provided by removing a service panel of the outdoor unit.

The heat generating electric components attached to the thermally conductive block are cooled through the thermally conductive block attached to the refrigerant pipe. In other words, the plurality of heat generating electric components mounted on the substrate are cooled by using the thermally conductive block as a heat sink.

The thermally conductive block includes the first surface extending substantially in parallel to the substrate at the predetermined interval from the substrate, and at least one of the heat generating electric components is attached to the first surface. A fixation hole needs to be formed in the substrate to allow access of a tool from the substrate side when the heat generating electric components are attached to the thermally conductive block. The tool is inserted into the fixation hole from the substrate side to fix the body parts of the heat generating electric components to the thermally conductive block by, for example, a screw. However, the fixation hole leads to reduction in the occupancy area of the substrate and hence reduction in the pattern width of the substrate, making it difficult to obtain a sufficient current capacity.

Since the SIP type heat generating electric component is provided with a connection terminal (lead pin) only on one side, interference between a tool and the substrate when the body part of the SIP type heat generating electric component is fixed to the second surface intersecting with the first surface does not need to be taken into consideration, and thus no fixation hole needs to be formed in the substrate. This leads to reduction in the number of fixation holes provided in the substrate. Thus, when the heat generating electric components are intensively disposed at part of the substrate, reduction in the pattern width of the substrate due to the fixation holes can be avoided, thereby achieving a sufficient current capacity and preventing reduction in mechanical strength.

Since the third surface to which the refrigerant pipe is attached is disposed facing to the opening part provided by removing the service panel of the outdoor unit, access from the service panel side is allowed when the refrigerant pipe is attached to the thermally conductive block, thereby improving the operability. Accordingly, the operability at attachment and removal of the substrate is improved, thereby achieving improved maintainability.

The thermally conductive block is preferably made of material such as metal having an excellent thermal conductivity, and is preferably made of, for example, aluminum alloy.

In addition, in the air conditioner controller according to the present invention, the thermally conductive block may be separable into a substrate side part including the first surface and the second surface and a refrigerant pipe side part including the third surface.

When the thermally conductive block is separable into the substrate side part including the first surface and the second surface and the refrigerant pipe side part including the third surface, the work of attachment of the heat generating electric components attached to the substrate to the first surface and the second surface, and the work of attachment of the refrigerant pipe to the third surface can be performed separately from each other. This achieves further improvement in the operability.

In addition, in the air conditioner controller according to the present invention, the substrate side part and the refrigerant pipe side part of the thermally conductive block may be fixed in an engage state.

When the substrate side part and the refrigerant pipe side part of the thermally conductive block are fixed in an engage state, this allows reliably positioning at attachment, thereby improving the operability.

In addition, in the air conditioner controller according to the present invention, a heat releasing sheet may be interposed at a junction part between the substrate side part and the refrigerant pipe side part of the thermally conductive block.

The heat releasing sheet interposed at the junction part between the substrate side part and the refrigerant pipe side part of the thermally conductive block can reduce contact thermal resistance at the junction part. This configuration provides an improved heat releasing property of the thermally conductive block.

The heat releasing sheet is preferably made of a material that has an excellent thermal conductivity and can be filled without leaving an air gap in the junction part, and is, for example, a silicon sheet.

In addition, in the air conditioner controller according to the present invention, a relief part may be provided at the substrate side part or the refrigerant pipe side part of the thermally conductive block to avoid sandwiching of an end part of the heat releasing sheet.

When the relief part for avoiding sandwiching of the end part of the heat releasing sheet is provided at the substrate side part or the refrigerant pipe part, this configuration allows junction of the substrate side part and the refrigerant pipe side part while the heat releasing sheet is disposed partially in the relief part, which facilitates application the heat releasing sheet, thereby improving the operability.

In addition, in the air conditioner controller according to the present invention, a notch may be provided at a corner of the thermally conductive block.

When the notch is provided at the corner of the thermally conductive block, this configuration enables to avoid collision between a protruding corner and any other component, thereby improving the operability. In addition, cooling performance is further improved because air flows through a space formed by the notch.

An air conditioner according to the present invention includes the air conditioner controller in any one of the above descriptions, and an outdoor unit housing the air conditioner controller.

Since the air conditioner controller in any one of the above descriptions is included, the air conditioner can provide an excellent operability at attachment and removal of the air conditioner controller.

An SIP type heat generating electric component is attached to a second surface intersecting with a first surface substantially parallel to the substrate, thereby achieving a reduced number of fixation holes formed in a substrate. A third surface to which a refrigerant pipe is attached is disposed facing to an opening part provided by removing a service panel of an outdoor unit, thereby achieving improved operability at attachment and removal.

### BRIEF DESCRIPTION OF THE SEVERAL VIEWS OF THE DRAWINGS

FIG. 1 is a schematic configuration diagram illustrating a refrigerant circuit of an air conditioner according to an embodiment of the present invention.
FIG. 2 is a perspective view of an outdoor unit of the air conditioner illustrated in FIG. 1, illustrating a state in which an outer panel thereof is removed.
FIG. 3 is a plan view illustrating attachment of a controller illustrated in FIG. 2.
FIG. 4 is a side view illustrating a substrate and an aluminum block illustrated in FIG. 3.
FIG. 5 is a plan view illustrating a separated state of the aluminum block.
FIG. 6 is a plan view illustrating a modification.
FIG. 7 is a plan view illustrating a modification.
FIG. 8 is a plan view illustrating a modification.
FIG. 9 is a plan view illustrating a modification.

### DETAILED DESCRIPTION OF THE INVENTION

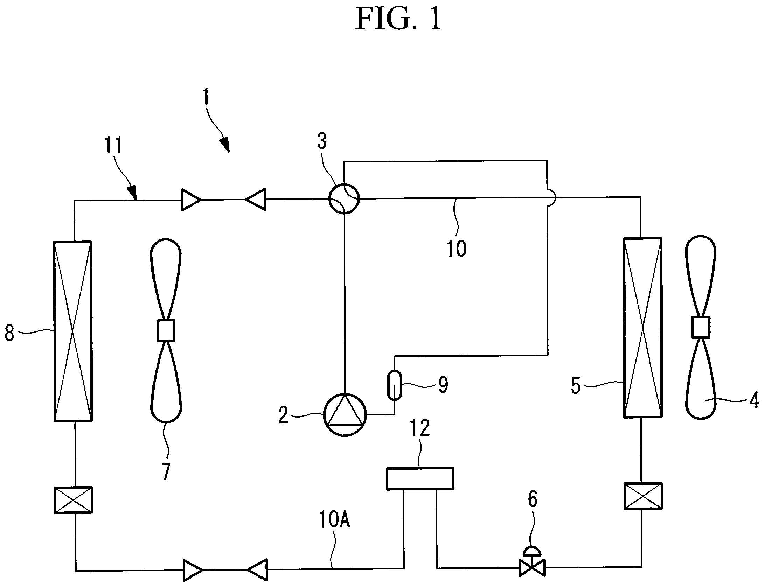

FIG. 1 illustrates a refrigerant circuit diagram of an air conditioner used for an air conditioner controller according to an embodiment of the present invention.

An air conditioner 1 includes, for example, a compressor 2 configured to compress a refrigerant, a four-way switching valve 3 configured to switch a circulation direction of the refrigerant, an outdoor heat exchanger 5 configured to perform heat exchange between the refrigerant and external air from an outdoor fan 4, electric expansion valve (expansion valve; EEV) 6 configured to expand the refrigerant, an indoor heat exchanger 8 configured to perform heat exchange between the refrigerant and indoor air from an indoor fan 7, and an accumulator 9, and these instruments are connected with each other through a refrigerant pipe 10 in a closed refrigeration cycle 11.

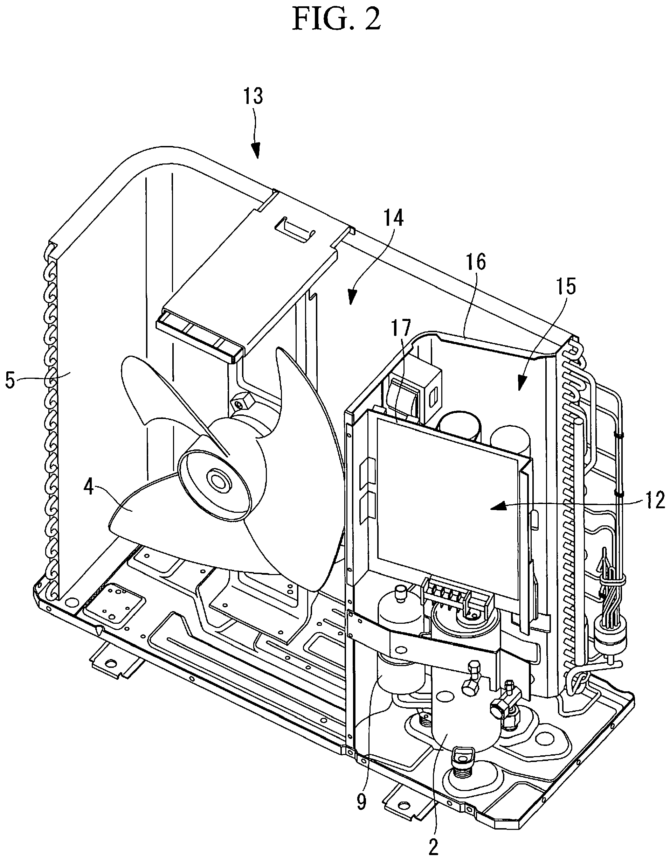

As illustrated in FIG. 2, a controller 12 configured to control drive of the air conditioner 1 based on a drive command from, for example a remote controller, is housed in an outdoor unit 13 provided with the outdoor heat exchanger 5. The controller 12 includes an inverter configured to control a rotation speed of the compressor 2, and has functions of switching the four-way switching valve 3 depending on a drive mode, and controlling the rotation speed of the outdoor fan 4, the rotation speed of the indoor fan 7, the degree of opening of the electric expansion valve 6, and the like.

The controller 12 is provided with electric components such as an active converter, a diode module, and a power transistor serving as the inverter. These electric components are heat generating electric components, and thus the controller 12 needs to be cooled. In the present embodiment, as illustrated in FIG. 1, for example, a refrigerant pipe 10A between the electric expansion valve (EEV) 6 and the indoor heat exchanger 8 included in the refrigeration cycle 11 is disposed in contact with the controller 12. At cooling, the controller 12 is cooled by the gas-liquid two-phase refrigerant at low pressure narrowed at the electric expansion valve 6 and flowing through the refrigerant pipe 10A. At heating, the controller 12 is cooled by the liquid refrigerant at high pressure condensed and liquefied at the indoor heat exchanger 8 and flowing through the refrigerant pipe 10A.

The refrigerant pipe disposed in contact with the controller 12 is not necessarily a pipe connecting the electric expansion valve (EEV) 6 and the indoor heat exchanger 8 as described above. The refrigerant pipe may be any refrigerant pipe that can be maintained at a temperature level in a range within which an effect of cooling the heat generating electric components provided on the controller 12 is expected, and may be another pipe part such as a refrigerant pipe connecting the electric expansion valve (EEV) 6 and the outdoor heat exchanger 5 or a low-pressure gas refrigerant pipe.

As illustrated in FIG. 2, the controller 12 is disposed at an appropriate place inside the outdoor unit 13 in which the compressor 2, the four-way switching valve 3, the outdoor fan 4, the outdoor heat exchanger 5, the electric expansion valve (EEV) 6, the accumulator 9, and the like included in the air conditioner 1 are housed and installed. In the present embodiment, the controller 12 is partitioned, by a partition plate 16, from the outdoor fan 4 inside of the outdoor unit 13 and an exchanger room 14 in which the outdoor heat exchanger 5 is installed. The controller 12 is installed, through a bracket 17, at an upper part on a side closer to a machine room 15 in which the compressor 2, the four-way switching valve 3, the electric expansion valve (EEV) 6, the accumulator 9, and the like are installed.

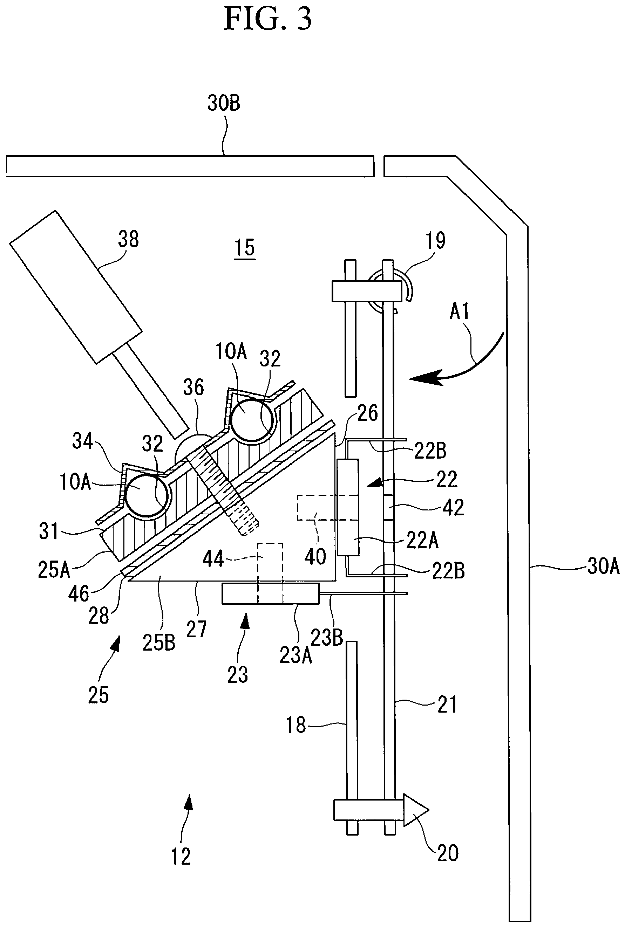

As illustrated in FIG. 3, the controller 12 is disposed in the machine room 15 enclosed by service panels 30A and 30B as part of a housing of the outdoor unit 13. The service panels 30A and 30B are configured to be opened or removed at maintenance.

The controller 12 includes a controller body 18 and a substrate 21. The controller body 18 includes a hinge unit 19 on one side and a click unit 20 on the other side. After one side of the substrate 21 is engaged with the hinge unit 19 on the one side, the substrate 21 is rotated in the direction of arrow A1 to hook and fix the other side of the substrate 21 to the click unit 20.

Various kinds of control circuits, a large number of electric components included in these circuits, and the like are mounted on the substrate 21. FIG. 3 illustrates a mounting structure and a cooling structure of a plurality of heat generating electric components such as an active converter, a diode module, and a power transistor, which are components of an inverter configured to drive an electric motor for the compressor 2, as described below.

The substrate 21 is provided thereon with a dual inline package (DIP) type heat generating electric component 22 including a plurality of lead pins 22B extending downward from both side surfaces of a package body 22A, and a single inline package (SIP) type heat generating electric component 23 including a plurality of lead pins 23B extending in line from one side of a package body 23A.

The DIP type heat generating electric component 22 is mounted substantially in parallel to a substrate surface of the substrate 21, and the SIP type heat generating electric component 23 is mounted substantially vertical to the substrate surface of the substrate 21.

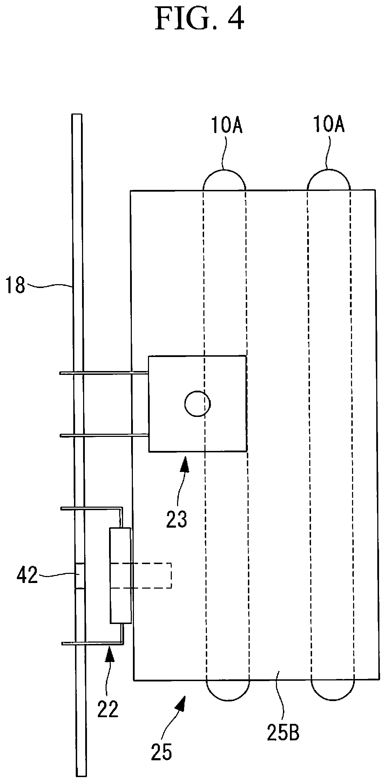

An aluminum block (thermally conductive block) 25 made of aluminum alloy material is installed at a position opposite to the substrate 21 and separated by a predetermined interval from the substrate 21. As illustrated in FIGS. 3 and 4, the aluminum block 25 substantially has a triangle pole shape having a long axis in a vertical direction.

As illustrated in FIG. 3, the aluminum block 25 includes a refrigerant pipe fixing part (refrigerant pipe side part) 25A at which the refrigerant pipe 10A is fixed, and an electric component fixing part (substrate side part) 25B at which the heat generating electric components 22 and 23 are fixed.

The refrigerant pipe fixing part 25A of the aluminum block 25 is an elongated plate, one surface of which facing to the service panel 30B is a refrigerant pipe fixation surface (third surface) 31. Two groove portions 32 having semicircular cross-sections are formed on the refrigerant pipe fixation surface 31 in parallel to each other in the vertical direction. The refrigerant pipe 10A is housed in each of these groove portions 32, covered by a bracket 34, and fixed by a bracket fixing screw (not illustrated). Although not illustrated, a heat releasing sheet is preferably disposed between the refrigerant pipe 10A and the groove portion 32.

The electric component fixing part 25B of the aluminum block 25 has a right-angled triangle cross-section, and includes a parallel surface (first surface) 26 extending substantially in parallel to the substrate surface of the substrate 21 at a predetermined interval therefrom, an orthogonal surface (second surface) 27 substantially orthogonally intersecting with the parallel surface 26, and a tilted surface 28 connecting the parallel surface 26 and the orthogonal surface 27.

The DIP type heat generating electric component 22 is disposed in contact with the parallel surface 26 of the electric component fixing part 25B. In this state, the package body 22A of the DIP type heat generating electric component 22 is fixed to the aluminum block 25 by a component fixing screw 40. A tool needs to be inserted from the substrate 21 side to fasten the component fixing screw 40, and thus a fixation hole 42 that is a through-hole is formed in the substrate 21.

The SIP type heat generating electric component 23 is disposed in contact with the orthogonal surface 27 of the electric component fixing part 25B. In this state, the package body 23A of the SIP type heat generating electric component 23 is fixed to the aluminum block 25 by a component fixing screw 44. The substrate 21 is not disposed at a position interfering a tool used to fasten the component fixing screw 44, and thus no fixation hole for fixing the SIP type heat generating electric component 23 needs to be formed in the substrate 21.

A heat releasing sheet 46 is interposed at a junction part between the refrigerant pipe fixing part 25A and the electric component fixing part 25B of the aluminum block 25. The heat releasing sheet 46 is provided to reduce contact thermal resistance between the refrigerant pipe fixing part 25A and the electric component fixing part 25B. The heat releasing sheet 46 is preferably made of a material that has an excellent thermal conductivity and can be filled without leaving an air gap in the junction part between the refrigerant pipe fixing part 25A and the electric component fixing part 25B, and is, for example, a silicon sheet.

The refrigerant pipe fixing part 25A and the electric component fixing part 25B of the aluminum block 25 are assembled with each other by an aluminum block connecting screw 36 while the heat releasing sheet 46 is interposed therebetween. FIG. 3 illustrates a tool 38 used to fasten the aluminum block connecting screw 36. This configuration allows the tool 38 to have access through the service panel 30B, which can provide an opening part in the housing of the outdoor unit 13, to fasten the aluminum block connecting screw 36.

The air conditioner 1 with the above-described configuration operates as described below.

In cooling drive mode of the air conditioner 1, the refrigerant flows, from the compressor 2 through the four-way switching valve 3, into a circuit in which the refrigerant circulates through the outdoor heat exchanger 5, the electric expansion valve 6, the indoor heat exchanger 8, the four-way switching valve 3, the accumulator 9, and the compressor 2. In heating drive mode of the air conditioner 1, the refrigerant flows, from the compressor 2 through the four-way switching valve 3, into a circuit in which the refrigerant circulates the indoor heat exchanger 8, the electric expansion valve 6, the outdoor heat exchanger 5, the four-way switching valve 3, the accumulator 9, and the compressor 2.

In cooling or heating drive mode of the air conditioner 1, the controller 12 performs control of various kinds of instruments such as control of the rotation speed of a drive motor of the compressor 2 through the inverter. In this case, the electric components 22 and 23 such as an active converter, a diode module, and a power transistor of the inverter mounted on the controller 12 are driven and generate heat. These heat generating electric components 22 and 23 need to be appropriately cooled to avoid overheating and allow the inverter to reliably drive and function for a long time period.

In cooling or heating drive mode, the temperature of the refrigerant flowing through the refrigerant pipe 10A of the refrigeration cycle 11 is sufficiently lower than the temperature of the heat generation of the heat generating electric components 22 and 23. Thus, the aluminum block 25, which is cooled in contact with the refrigerant pipe 10A, can be used as a heat sink to achieve cooling through releasing of the heat generated by the heat generating electric components 22 and 23 such as an active converter, a diode module, and a power transistor, thereby reliably cooling the electric components 22 and 23 to be not higher than an allowance temperature. Accordingly, the inverter can reliably function for a long time period.

The aluminum block 25 is attached to the controller 12 with the above-described configuration as follows.

The electric component fixing part 25B of the aluminum block 25 is attached to the heat generating electric components 22 and 23 mounted on the substrate 21. Specifically, a tool is inserted from the substrate 21 side through the fixation hole 42 formed in the substrate 21 to fix the DIP type heat generating electric component 22 to the electric component fixing part 25B by the component fixing screw 40. Since a tool does not interfere with the substrate 21, the SIP type heat generating electric component 23 is fixed to the electric component fixing part 25B by the component fixing screw 44 without using the fixation hole 42 formed in the substrate 21. Once a subassembly of the substrate 21 and the electric component fixing part 25B is formed in this manner, the service panel 30A is opened to access the inside of the outdoor unit 13 to attach the subassembly to the controller body 18. At the attachment to the controller body 18, after the one side of the substrate 21 is engaged with the hinge unit 19, the substrate 21 is rotated to hook and fix the other side of the substrate 21 to the click unit 20.

When the service panel 30B is opened to access the inside of the outdoor unit 13, the refrigerant pipe fixing part 25A of the aluminum block 25 is attached to the refrigerant pipe 10A inside of the outdoor unit 13. Since the refrigerant pipe 10A is already disposed inside of the outdoor unit 13, such work needs to be done inside of the outdoor unit 13. The refrigerant pipe 10A is first housed each groove portion 32 of the refrigerant pipe fixing part 25A, and then fixed to the refrigerant pipe fixing part 25A by a bracket fixing screw (not illustrated) while being covered by the bracket 34.

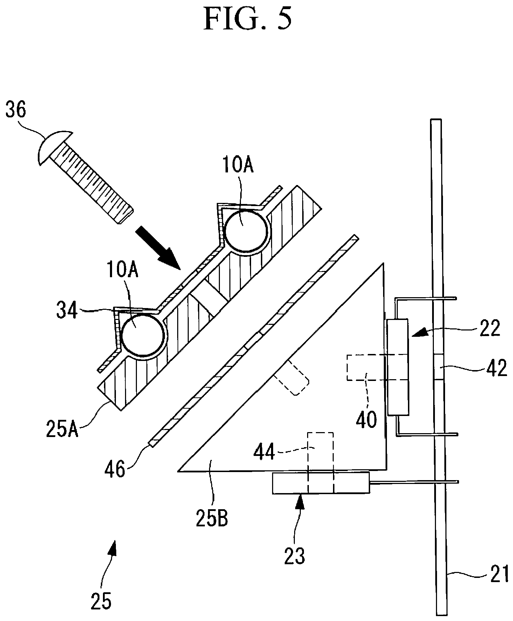

Then, as illustrated in FIG. 5, the refrigerant pipe fixing part 25A and the electric component fixing part 25B are integrally connected with each other through fastening of the aluminum block connecting screw 36 by using the tool 38 while the heat releasing sheet 46 is interposed between the refrigerant pipe fixing part 25A and the electric component fixing part 25B. This completes the attachment of the aluminum block to the controller 12.

The present embodiment achieves the following effect.

The refrigerant pipe fixation surface 31 of the aluminum block 25 to which the refrigerant pipe 10A is attached is disposed facing to the opening part provided by removing the service panel 30B of the outdoor unit 13, which allows access from the service panel 30B side to attach the refrigerant pipe 10A to the aluminum block 25, thereby improving the operability. Accordingly, the operability at attachment and removal of the substrate 21 is improved, thereby achieving improved maintainability.

Since the SIP type heat generating electric component 23 is provided with the lead pins 23B only on one side, interference between a tool and the substrate 21 when the SIP type heat generating electric component 23 is fixed to the orthogonal surface 27 of the aluminum block 25 does not need to be taken into consideration, and thus no fixation hole needs to be formed in the substrate 21. This leads to reduction in the number of fixation holes provided in the substrate 21. Thus, when the heat generating electric components 22 and 23 are intensively disposed at part of the substrate 21, reduction in the pattern width of the substrate 21 due to the fixation holes is avoided, thereby achieving a sufficient current capacity and preventing reduction in mechanical strength.

Since the aluminum block 25 is separable into the refrigerant pipe fixing part 25A and the electric component fixing part 25B, the work of attachment of the heat generating electric components 22 and 23 attached to the substrate 21 to the electric component fixing part 25B, and the work of attachment of the refrigerant pipe 10A to the refrigerant pipe fixing part 25A can be performed separately from each other. This achieves further improvement in the operability.

The present embodiment may be modified as described below.

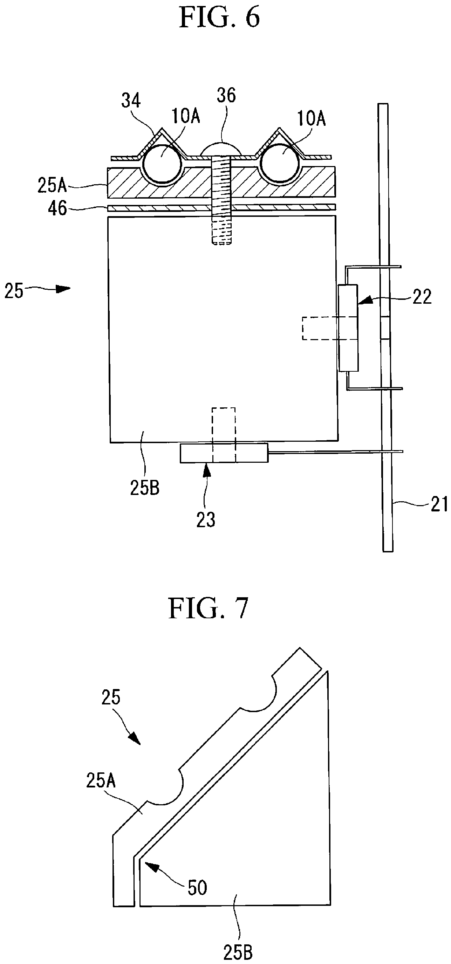

The cross-section of the aluminum block 25 is not limited to a triangle. Specifically, as illustrated in FIG. 6, the aluminum block 25 may have a substantially rectangular section. In this case, the cross-section of the electric component fixing part 25B is a rectangle.

Alternatively, as illustrated in FIG. 7, the refrigerant pipe fixing part 25A and the electric component fixing part 25B may be fixed in an engaged state. Specifically, as illustrated in FIG. 7, a bent part 50 is formed at the junction part between the refrigerant pipe fixing part 25A and the electric component fixing part 25B. This allows reliable positioning at attachment, thereby improving the operability.

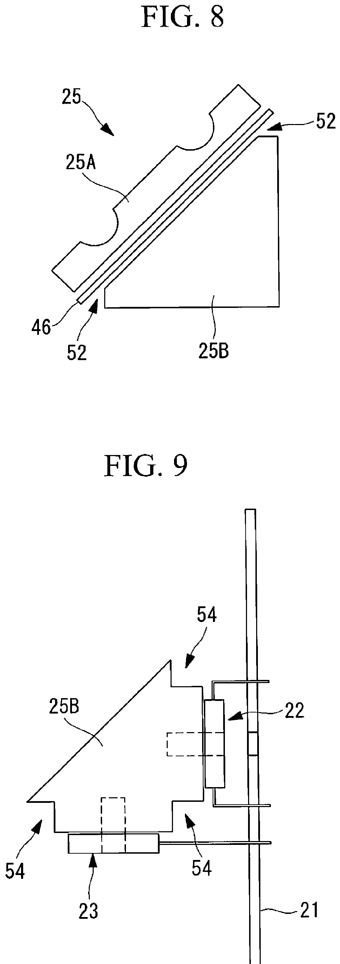

Alternatively, as illustrated in FIG. 8, end parts of the electric component fixing part 25B of the aluminum block 25 may be removed to provide relief parts 52 so as to prevent an end part of the heat releasing sheet 46 from being sandwiched between the refrigerant pipe fixing part 25A and the electric component fixing part 25B. This configuration allows junction of the refrigerant pipe fixing part 25A and the electric component fixing part 25B while the heat releasing sheet 46 is disposed partially in the relief parts 52, which facilitates application of the heat releasing sheet 46, thereby improving the operability. The relief part may be provided at the refrigerant pipe fixing part 25A.

Alternatively, as illustrated in FIG. 9, notches 54 may be provided at corners of the electric component fixing part 25B of the aluminum block 25. This configuration enables to avoid collision between a protruding corner and any other component, thereby improving the operability. In addition, cooling performance is further improved because air flows through spaces formed by the notches 54. The shape of the notches 54 may be rectangular at a section as illustrated in FIG. 9, a chamfered shape, or a curved surface shape.

The above description of the embodiment and modifications is made on the aluminum block 25. However, the material of the block is not limited to aluminum alloy, and may be any other metal having an excellent thermal conductivity.

### Reference Signs List

1 air conditioner
10A refrigerant pipe
12 controller
13 outdoor unit
17 bracket
18 controller body
19 hinge unit
20 click unit
21 substrate
22 DIP type electric component (heat generating electric component)
22A, 23A package body
23 SIP type electric component (heat generating electric component)
25 aluminum block (thermally conductive block)
25A refrigerant pipe fixing part (the refrigerant pipe side part)
25B electric component fixing part (substrate side part)
26 parallel surface (first surface)
27 orthogonal surface (second surface)
28 tilted surface
30A, 30B service panel
31 refrigerant pipe fixation surface (third surface)
32 groove portion
34 bracket
36 aluminum block connecting screw
38 tool
40 component fixing screw
42 fixation hole
44 component fixing screw
46 heat releasing sheet
50 bent part
52 relief part
54 notch

## Claims

1. An air conditioner controller (12) comprising:
a plurality of heat generating electric components (22, 23) installed in an outdoor unit (13) of an air conditioner (1) to control instruments of the air conditioner (1);
a substrate (21) on which the heat generating electric components (22, 23) are mounted; and
a thermally conductive block (25) to which body parts of the heat generating electric components (22, 23) are fixed in contact and that is attached to a refrigerant pipe (10A),
wherein the thermally conductive block (25) includes a first surface (26) that extends substantially in parallel to the substrate (21) at a predetermined interval from the substrate (21) and to which at least one of the heat generating electric components (22, 23) is attached, a second surface (27) that intersects with the first surface (26) and to which at least one SIP type heat generating electric component (23) among the heat generating electric components (22, 23) is attached, and a third surface (31) to which the refrigerant pipe (10A) is attached, and
wherein the third surface (31) is disposed facing to an opening part provided by removing a service panel (30A, 30B) of the outdoor unit (13).

2. The air conditioner controller (12) according to claim 1, wherein the thermally conductive block (25) is separable into a substrate side part (25B) including the first surface (26) and the second surface (27) and a refrigerant pipe side part (25A) including the third surface (31).

3. The air conditioner controller (12) according to claim 2, wherein the substrate side part (25B) and the refrigerant pipe side part (25A) of the thermally conductive block (25) are fixed in an engaged state.

4. The air conditioner controller (12) according to claim 2 or 3, wherein a heat releasing sheet (46) is interposed at a junction part between the substrate side part (25B) and the refrigerant pipe side part (25A) of the thermally conductive block (25).

5. The air conditioner controller (12) according to claim 4, wherein a relief part (52) is provided at the substrate side part (25B) or the refrigerant pipe side part (25A) of the thermally conductive block (25) to avoid sandwiching of an end part of the heat releasing sheet (46).

6. The air conditioner controller according to any one of claims 1 to 5, wherein a notch (54) is provided at a corner of the thermally conductive block (25).

7. An air conditioner (1) comprising:
the air conditioner controller (12) according to any one of claims 1 to 6; and
an outdoor unit (13) housing the air conditioner controller (12).
